# EUROPEAN PATENT APPLICATION

(11) **EP 1 703 557 A2**
(43) Date of publication of application: **20.09.2006**
(21) Application number: 06075528.7
(22) Date of filing: 07.03.2006
(51) Int. Cl.: H01L 23/427, H01L 23/373, H01L 23/367, H01L 23/31

(54) **Electronic assembly with integral thermal transient suppression**

(30) Priority: 17.03.2005 US 82547
(71) Applicant: Delphi Technologies, Inc., Troy, MI 48007 (US)
(72) Inventor: Chengalva, Suresh K., Carmel, IN 46032 (US); Myers, Bruce A., Kokomo, IN 46901 (US); Walsh, Matthew R., Sharpsville, IN 46068 (US)
(74) Representative: Denton, Michael John

(57) **Abstract**

An electronic assembly (100) with integral thermal transient suppression includes an integrated circuit (IC) chip (106) disposed within a cavity (103) of an IC device package (102). A transient thermal suppression material (TTSM) (110) is disposed in the cavity (103) in thermal contact with the IC chip (106). A heat sink (112) may also be provided in thermal contact with the chip (106). When present, the heat sink (112) serves as a cover of the packaged IC chip (106) and may include fins (112A,112B) extending from an upper surface (in contact with air) and a lower surface (in thermal contact with the TTSM (110)).The TTSM (110) may be thought of as a phase change material that absorbs energy dissipated by the IC chip (106) in a phase change event.

## Description

### TECHNICAL FIELD

The present invention is generally directed to an electronic assembly and, more specifically, to an electronic assembly with integral thermal transient suppression.

### BACKGROUND OF THE INVENTION

In general, higher power integrated circuit (IC) components require heat removal from the components to prevent early failure of the components. In various applications, high-power components may have relatively short, e.g., a few seconds, high-power thermal transient events. In general, the amount of thermal energy dissipated in these high-power thermal transient events needs to be dissipated rapidly and expediently.

In various electronic assemblies, a high-power thermal transient event may repeatedly occur and, if the energy is not continuously dissipated, heat may build up in the electronic components of the assemblies, causing failure of the components. In general, assembly designers have addressed short-term high-power thermal transients by implementing high-performance steady-state thermal structures to absorb the short-term high-power thermal transients. Unfortunately, high-performance steady-state thermal structures, such as heat sinks, fans, etc., tend to be relatively expensive to implement. When implemented, heat sinks have typically been provided on a top side of an electronic component. Alternatively, some electronic assemblies have utilized relatively expensive via structures implemented in a substrate underneath an electronic component, e.g., an integrated circuit (IC) chip.

What is needed is a technique for providing thermal transient suppression for an electronic assembly that is relatively inexpensive and efficient.

### SUMMARY OF THE INVENTION

The present invention is directed to an electronic assembly that includes integral thermal transient suppression. In one embodiment, an electronic assembly includes an integrated circuit (IC) device package that includes a cavity. In this embodiment, an IC chip is disposed within the cavity and a transient thermal suppression material (TTSM) is disposed in the cavity in thermal contact with the IC chip. According to another embodiment of the present invention, a heat sink is also provided in thermal contact with the chip. In this embodiment, the heat sink serves as a cover of the packaged IC chip. According to another embodiment, the heat sink includes fins extending from an upper surface of the heat sink. In still another embodiment, the heat sink includes fins extending from a lower surface of the heat sink with the fins being in thermal contact with the TTSM. In general, the TTSM may be thought of as a phase change material that absorbs energy dissipated by the IC chip in a phase change event.

According to another embodiment of the present invention, an electronic assembly with integral thermal suppression includes an integrated circuit (IC) chip and a thermal transient suppression material (TTSM) that is disposed in grooves that are formed in a non-active side of a body of the IC chip. According to this aspect of the present invention, a dam is located at opposite ends of the grooves to retain the TTSM. The dam may be made of an epoxy or may be integral to the body of the IC chip. According to still another aspect of the present invention, the assembly includes a substrate that has a plurality of conductive traces, which are coupled to the IC chip on an active side of the IC chip.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Fig. 1 is a cross-sectional view of an exemplary electronic assembly configured according to one embodiment of the present invention;
Fig. 2 is a graph including a plurality of curves that illustrate transient thermal performance for various device packages;
Fig. 3A-3C are perspective, top and cross-sectional views, respectively, of an exemplary electronic assembly constructed according to another embodiment of the present invention; and
Fig. 4 is a graph including a plurality of curves that illustrate transient thermal performance for a variety of different device packages.

### DESCRIPTION OF THE PREFERRED EMBODIMENTS

According to one embodiment of the present invention, a technique for removing heat from a modified device package is disclosed. As is discussed above, high-power electronic components require heat removal to prevent failure. As is also discussed above, many devices experience relatively short high-power thermal transient events. According to one aspect of the present invention, a phase change thermal transient suppression material (TTSM) is implemented within a dual in-line package (DIP) cavity, to absorb transient thermal energy. In certain situations, it may also be desirable to implement a heat sink that is placed in contact with a thermal transient suppression material (TTSM) to improve steady-state thermal performance.

In general, an electronic assembly configured according to this embodiment of the present invention provides a reduced cost product, as contrasted with assemblies that implement conventional cooling concepts, that allows for the utilization of a device package cover that may be made of a variety of materials, such as metals with large heat capacity, e.g., copper. According to one aspect of the present invention, heat is removed from a top side of a die, located in a cavity package, to air through a modified package cover.

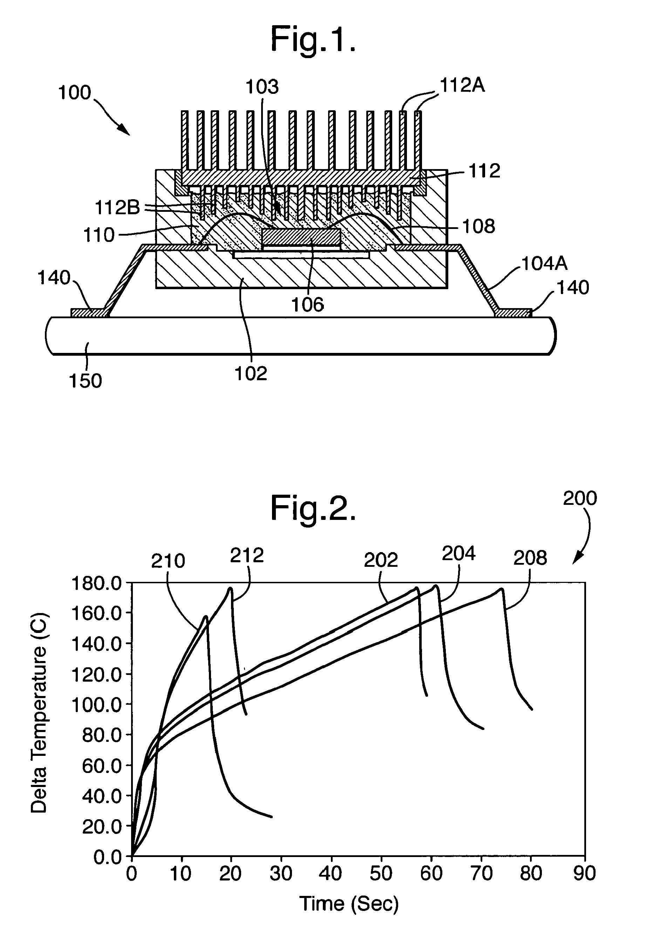

With reference to Fig. 1, a portion of an exemplary electronic assembly 100 is depicted that utilizes an integrated circuit (IC) device package 102, e.g., a DIP package, which includes a cavity 103. An IC chip 106 is disposed within the cavity 103 and a thermal transient suppression material (TTSM) 110 is disposed in the cavity 103, in thermal contact with the IC chip 106. As is also shown in Fig. 1, wires 108 are coupled to leads 104A, which extend from the package 102 and are connected to electrical traces 140 formed on a surface of substrate 150.

The assembly 100 may also include a heat sink 112 having lower fins 112B and/or upper fins 112A. As is shown, the fins 112B are in contact with the TTSM 110 and the heat sink 112 serves as a cover for the packaged IC chip 106. The clearance between the TTSM 110 and the cover may be about ten to fifteen mils. The TTSM 110 may be a variety of materials, such as those disclosed in U.S. Patent No. 6,703,128, entitled "THERMALLY-CAPACITIVE PHASE CHANGE ENCAPSULANT FOR ELECTRONIC DEVICES," to Bruce A. Myers et al., which is hereby incorporated herein by reference in its entirety.

With reference to Fig. 2, a graph 200 is depicted, which includes a plurality of curves 202, 204, 208, 210 and 212, which graph the transient thermal performance of various exemplary electronic assemblies. For example, the curves 210 and 212 show the transient thermal performance of an electronic assembly having a dual in-line package (DIP) whose cavity does not include a TTSM and that does not implement a heat sink. Additionally, the curves 202 and 204 graph the thermal performance for electronic assemblies having a DIP that includes a TTSM in the DIP cavity and a heat sink and the curve 208 graphs the thermal performance for an electronic assembly having a DIP whose cavity includes a TTSM.

As is apparent from the graph 200, electronic assemblies that include a TTSM within a device cavity have substantially decreased temperature transients. The curves of Fig. 2 show die temperature rise as a function of time with the same power applied to the chip in all cases. The curves of Fig. 2, with the TTSM material, take a much longer time to reach maximum temperature. This is caused by the thermal energy absorbed by the TTSM as it undergoes a phase change. The longer the time it takes for the die to reach its maximum temperature, the more transient thermal energy the device can withstand before it fails. Thus, a device with TTSM material will generally maintain a lower temperature than a device without the TTSM material, when exposed to the same thermal transient.

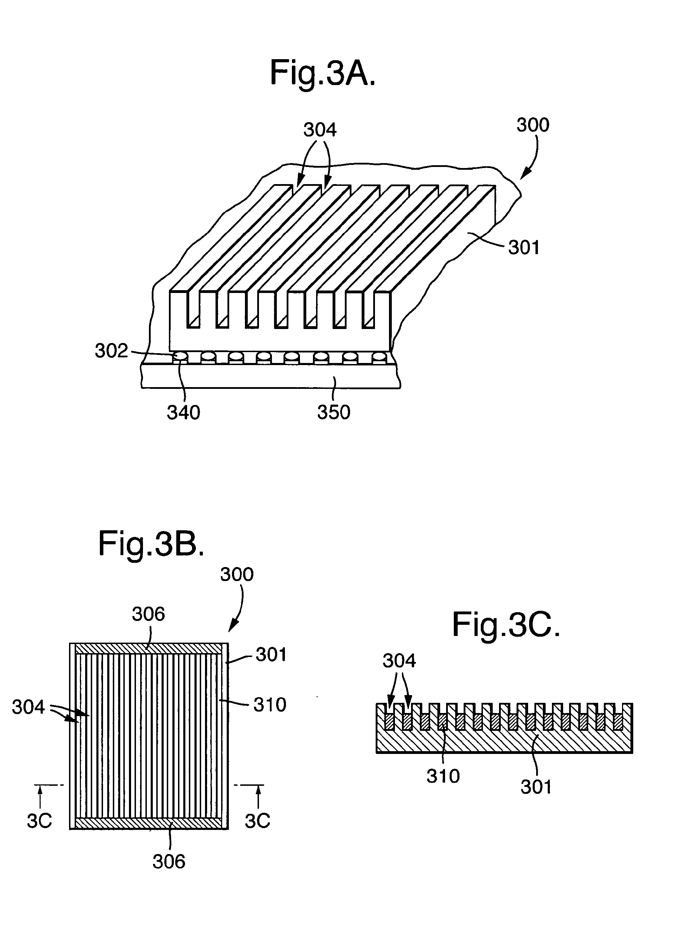

With reference to Fig. 3A-3C, an electronic assembly 300, constructed according to another embodiment of the present invention, is depicted. With specific reference to Fig. 3A, the electronic assembly 300 includes an integrated circuit (IC) flip chip 301 having solder bumps 302, which are electrically coupled to contacts 340 mounted on a surface of substrate 350. The chip 301 includes a plurality of parallel grooves 304 formed in a non-active side of a body of the IC chip 301. The grooves 304 may be, for example, about fifteen mils wide and about one-hundred mils deep, with a fin width of about fifteen mils.

As is best shown in Figs. 3B and 3C, a transient thermal suppression material (TTSM) 310 is disposed in the grooves 304 formed in the body of the chip 301. The TTSM 310 may have a depth of about fifty to sixty mils, with about forty to fifty mils of the fin extending above the TTSM 310. A dam 306 is located at opposite ends of the grooves 304 to retain the TTSM 310. The dam 306 may be made of, for example, an epoxy, or, alternatively, the dam 306 may be integral to the body of the IC chip 301. In this embodiment, the perimeter walls serve to form a container, as well as to stiffen the chip 301 to prevent breakage during thermal cycling. The portion of the groove 304 fins that project above the TTSM 310 can serve as a convector to enhance heat dissipation. The grooves 304 may be cut in the back of the chip 301 with a traditional wafer saw or can be etched and can have a wide range of dimensions.

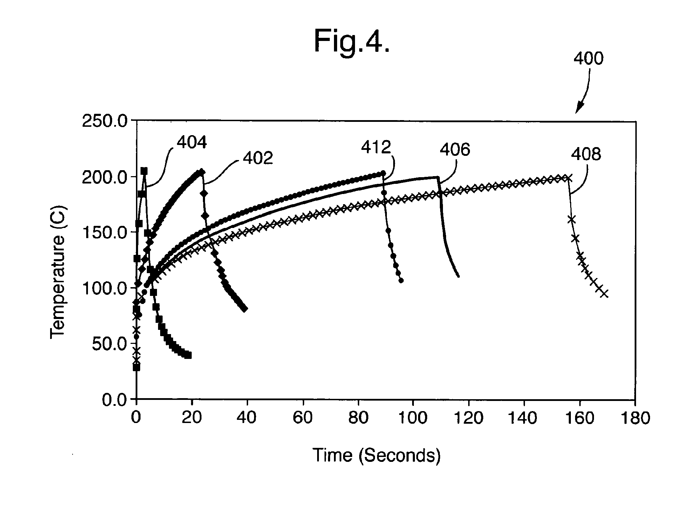

With reference to Fig. 4, a graph 400 is depicted, which includes a plurality of curves 402, 404, 406, 408 and 412, which depict the thermal characteristics of a number of flip chips, with and without grooves. Curve 402 corresponds to a flip chip that is ungrooved and that does not include a TTSM. Curve 404 corresponds to a grooved flip chip with no TTSM. Curve 412 corresponds to a grooved flip chip with TTSM deposited within the grooves of the flip chip. Curve 406 corresponds to an ungrooved flip chip with a TTSM and curve 408 corresponds to a grooved flip chip with a TTSM placed in the grooves.

From the curves of Fig. 4, it is apparent that the grooved flip chip with TTSM placed within the grooves provides superior thermal transient suppression, i.e., the flip chips that utilized a TTSM exhibit substantially decreased temperature transients. As above, the curves 402, 404, 406, 408 and 412 show die temperature rises as a function of time with the same power applied to the chip in all cases. The curves 406, 408 and 412, which correspond to cases where a TTSM material is used, take a much longer time to reach maximum temperature. This is due to the thermal energy absorbed by the TTSM as it undergoes a phase change. The longer it takes for the die to reach its maximum temperature, the more transient thermal energy the device can withstand before it fails. Thus, a device with TTSM material will maintain a lower temperature than a device without the TTSM material, when exposed to the same thermal transient.

Accordingly, electronic assemblies have been described herein, which include integral thermal transient suppression, which advantageously allow an electronic assembly to be produced more economically. Such an electronic assembly is particularly advantageous when implemented within the automotive environment, which increasingly utilize high-power devices that frequently experience thermal transients.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. An electronic assembly (100) with integral thermal transient suppression, comprising:
an integrated circuit (IC) device package (102), the package (102) including a cavity (103);
an IC chip (106) disposed within the cavity (103); and
a transient thermal suppression material (TTSM) (110) disposed in the cavity (103) in thermal contact with the IC chip (106).

2. The assembly (100) of claim 1, further comprising:
a heat sink (112) in thermal contact with the chip (106), wherein the heat sink (112) serves as a cover of the packaged IC chip (106).

3. The assembly (100) of claim 2, wherein the heat sink (112) includes fins (112A) extending from an upper surface of the heat sink (112).

4. The assembly (100) of claim 2, wherein the heat sink (112) includes fins (112B) extending from a lower surface of the heat sink (112), and wherein the fins (112B) are in thermal contact with the TTSM (110).

5. The assembly (100) of claim 2, wherein the heat sink (112) serves as a cover for the packaged IC chip (106).

6. The assembly (100) of claim 2, wherein the heat sink (112) includes upper fins (112A) extending from an upper surface of the heat sink (112) and lower fins (112B) extending from a lower surface of the heat sink (112), and wherein the heat sink (112) serves as a cover for the packaged IC chip (106) and the lower fins (112B) are in thermal contact with the TTSM (110).

7. The assembly (100) of claim 1, wherein the TTSM (110) is a phase change material that absorbs energy dissipated by the IC chip (106) in a phase change event.

8. An electronic assembly (300) with integral thermal transient suppression, comprising:
an integrated circuit (IC) chip (301), wherein a non-active side of a body of the IC chip (301) includes a plurality of parallel grooves (304); and
a transient thermal suppression material (TTSM) (310) disposed in the grooves (304) in thermal contact with the IC chip (301).

9. The assembly (300) of claim 8, further comprising:
a dam (306) located at opposite ends of the grooves (304), wherein the dam (306) retains the TTSM (310).

10. The assembly (300) of claim 9, wherein the dam (306) is made of an epoxy.

11. The assembly (300) of claim 9, wherein the dam (306) is integral to the body of the IC chip (301).

12. The assembly (300) of claim 8, wherein the TTSM (310) is a phase change material that absorbs energy dissipated by the IC chip (301) in a phase change event.

13. The assembly (300) of claim 8, further comprising:
a substrate (350) including a plurality of conductive traces (340), wherein an active side of the IC chip (301) is adjacent to the substrate (350) and is electrically coupled to the conductive traces (340).

14. A method for providing integral thermal transient suppression for an electronic assembly (100), comprising the steps of:
providing an integrated circuit (IC) device package (102), the package (102) including a cavity (103);
positioning an IC chip (106) within the cavity (103); and
position a transient thermal suppression material (TTSM) (110) in the cavity (103) in thermal contact with the IC chip (106), wherein the TTSM (110) suppresses thermal transients of the IC chip (106).

15. The method of claim 14, further comprising the step of:
positioning a heat sink (112) in thermal contact with the chip (106), wherein the heat sink (112) serves as a cover of the packaged IC chip (106).

16. The method of claim 15, wherein the heat sink (112) includes fins (112A) extending from an upper surface of the heat sink (112).

17. The method of claim 15, wherein the heat sink (112) includes fins (112B) extending from a lower surface of the heat sink (112), and wherein the fins (112B) are in thermal contact with the TTSM (110).

18. The method of claim 15, wherein the heat sink (112) serves as a cover for the packaged IC chip (106).

19. The method of claim 15, wherein the TTSM (110) is a phase change material that absorbs energy dissipated by the IC chip (106) in a phase change event.

20. A method for providing integral thermal transient suppression for an electronic assembly (300), comprising the steps of:
providing an integrated circuit (IC) chip (301);
forming a plurality of parallel grooves (304) in a non-active side of a body of the IC chip (301); and
positioning a transient thermal suppression material (TTSM) (310) in the grooves (304) in the body of the IC chip (301).

21. The method of claim 20, further comprising the step of:
providing a dam (306) located at opposite ends of the grooves (304), wherein the dam (306) retains the TTSM (310).

22. The method of claim 21, wherein the dam (306) is made of an epoxy.

23. The method of claim 21, wherein the dam (306) is integral to the body of the IC chip (301).

24. The method of claim 20, wherein the TTSM (310) is a phase change material that absorbs energy dissipated by the IC chip (301) in a phase change event.
